(19) Europäisches Patentamt / European Patent Office / Office européen des brevets

(11) **EP 3 489 699 B1**

(12) **EUROPÄISCHE PATENTSCHRIFT**

(45) Veröffentlichungstag und Bekanntmachung des Hinweises auf die Patenterteilung:
**12.03.2025 Patentblatt 2025/11**

(21) Anmeldenummer: **18205370.2**

(22) Anmeldetag: **09.11.2018**

(51) Internationale Patentklassifikation (IPC):
***G01H 11/00*** *(2006.01)*

(52) Gemeinsame Patentklassifikation (CPC):
**G01H 11/00; G01R 31/62;** G01H 11/04; G01N 27/72

(54) **KLASSIFIZIERUNG DES GERÄUSCHVERHALTENS VON FERROMAGNETISCHEN MATERIALIEN**

CLASSIFICATION OF THE NOISE BEHAVIOUR OF FERROMAGNETIC MATERIALS

CLASSIFICATION DU COMPORTEMENT DE BRUIT DE MATÉRIAUX FERROMAGNÉTIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.11.2017 DE 102017220419**

(43) Veröffentlichungstag der Anmeldung:
**29.05.2019 Patentblatt 2019/22**

(73) Patentinhaber: **Siemens Energy Global GmbH & Co. KG
81739 München (DE)**

(72) Erfinder:
• **Tanzer, Thomas**
**8182 Puch bei Weiz (AT)**
• **Pregartner, Helmut**
**8160 Krottendorf (AT)**

(56) Entgegenhaltungen:
WO-A1-2011/012159    CN-A- 101 521 402
CN-A- 106 643 877    JP-A- 2003 194 903
JP-A- H1 038 862    US-B1- 8 849 587

• BUYUNG SOFIARTO MUNIR ET AL: "Diagnosing winding and core condition of power transformer by vibration signal analysis", CONDITION MONITORING AND DIAGNOSIS (CMD), 2012 INTERNATIONAL CONFERENCE ON, IEEE, 23 September 2012 (2012-09-23), pages 429 - 432, XP032312570, ISBN: 978-1-4673-1019-2, DOI: 10.1109/CMD.2012.6416170
• PABLO H IBARGUENGOYTIA ET AL: "Transformer diagnosis using probabilistic vibration models", TRANSMISSION AND DISTRIBUTION CONFERENCE AND EXPOSITION, 2010 IEEE PES, IEEE, PISCATAWAY, NJ, USA, 19 April 2010 (2010-04-19), pages 1 - 8, XP031689226, ISBN: 978-1-4244-6546-0

**Beschreibung**

GEBIET DER ERFINDUNG

Die Erfindung betrifft ein Verfahren zur Klassifizierung des Geräuschverhaltens von ferromagnetischen Materialien, insbesondere von Elektroblech das für die Herstellung einer elektrischen Maschine verwendet wird, wobei eine Spule mit Wechselspannung beaufschlagt und zur Magnetisierung des Materials am zu klassifizierenden Material angeordnet wird, wobei der in der Spule vorliegende Magnetisierungsstrom über die Zeit gemessen wird, und das Quadrat des Magnetisierungsstroms bestimmt und zur Bestimmung des Maßes für die Geräuschentwicklung herangezogen wird.

Die Spule wird dabei so nahe am zu klassifizierenden Material angeordnet, dass eine Magnetisierung des Materials erreicht wird.

STAND DER TECHNIK

Wenn ferromagnetische Materialien einem sich zeitlich ändernden magnetischen Feld ausgesetzt sind, kommt es zu einer Längenänderung des Materials, die als Magnetostriktion bezeichnet wird. Werden die ferromagnetische Materialien als Bleche zur Fertigung eines Kerns für einen Leistungstransformator verwendet, so bedingt die durch die Wechselspannung induzierte Längenänderung der Elektrobleche eine Geräuschentwicklung, die oft unerwünscht ist.

Deshalb wird das Elektroblech vor dem Verbauen in einer elektrischen Maschine hinsichtlich seines Magnetostriktions-Verhaltens untersucht. Die Magnetostriktion kann dabei mit direkten und indirekten Messmethoden bestimmt werden.

Als direkte Methoden können die Messung mittels Dehnmessstreifen, kapazitiver Aufnehmer sowie optischer Methoden, wie Laserinterferometer, genannt werden. Bei diesen Methoden wird die Längenänderung des Materials während definierter magnetischer Zustände direkt gemessen. Indirekte Methoden, wie die FMR-Methode (Ferromagnetic Resonance Method), Becker-Kersten Methode oder SAMR-Methode (Small-angle-magnetization rotation), beruhen auf dem Villari Effekt. Hierbei wird im Gegensatz zu den direkten Methoden mechanisch Spannung in Form von Druck oder Zug am Material aufgebracht und daraus die Magnetostriktion abgeleitet.

Alle direkten und indirekten Methoden benötigen einen zusätzlichen Messaufbau mit ausreichend genauen Komponenten um die Magnetostriktion zu bestimmen. So wird etwa im technischen Bericht IEC/TR 62581 Edition 1.0 1020-08 eine direkte optische Methode beschrieben, welche bei den genormten Messeinrichtungen Epstein-Messgerät (IEC 60404-2) und Single-Sheet-Messgerät (IEC 60404-3) zur Bestimmung magnetischer Eigenschaften zum Einsatz kommt.

Das Epstein-Messgerät, das auch als Epstein-Rahmen bezeichnet wird, ist ähnlich wie ein Transformator aufgebaut. Es besteht aus einer gleichförmig verteilten äußeren Primärwicklung (auch Magnetisierungswicklung genannt) welche die innere Sekundärwicklung (Messwicklung) umschließt. Die zu vermessenden Streifen aus weichmagnetischem Elektroblech werden jeweils paarweise gegenüberliegend in die Spulen gelegt, so dass vier gleich lange Schenkel mit gleichem Querschnitt entstehen. Durch Messung des Stroms in der Primärwicklung und der Spannung in der Sekundärwicklung lassen sich die magnetische Feldstärke bzw. die magnetische Flussdichte in den Proben bestimmen.

In der WO 2011/012159 A1 wird durch die direkte Messung der Magnetostriktion, die durch eine Erregerwicklung induziert wird, mit Beschleunigungssensoren eine Klassifikation der Geräuschemission von ganzen Elektroblechwickeln durchgeführt.

Der Aufsatz "Diagnosing Winding and Core Condition of Power Transformer by Vibration Signal Analysis" von Buyung Sofiarto Munier, et al., Condition monitoring and Diagnosis (CMD) 2012 International Conference On, IEEE, 23. September 2012, Seiten 429 bis 432 geht ein Verfahren zur Klassifizierung des Geräuschverhaltens von ferromagnetischen Materialien hervor.

Weiteren Stand der Technik bildet die US 8,849,587 B1.

DARSTELLUNG DER ERFINDUNG

Es ist eine Aufgabe der Erfindung, ein Verfahren zur Klassifizierung des Geräuschverhaltens von ferromagnetischen Materialien, insbesondere von Elektroblechen, zur Verfügung zu stellen, welches keinen Messaufbau für mechanische oder optische Größen benötigt.

Diese Aufgabe wird durch ein Verfahren nach Anspruch 1 gelöst. Weitere Ausgestaltungen des Verfahrens sind in den abhängigen Ansprüchen enthalten.

Anspruch 1 umfasst den Schritt, wonach eine Spule mit Wechselspannung beaufschlagt und zur Magnetisierung des Materials am zu klassifizierenden Material angeordnet wird. Erfindungsgemäß umfasst das Verfahren zumindest die folgenden weiteren Schritte:

-  dass der in der Spule vorliegende Magnetisierungsstrom über die Zeit gemessen wird, und
-  dass das Quadrat des Magnetisierungsstroms bestimmt und zur Bestimmung des Maßes für die Geräuschentwicklung herangezogen wird.

Es wurde nämlich herausgefunden, dass der Magnetisierungsstrom einer Spule mit der Magnetostriktion korreliert. Es besteht ein linearer Zusammenhang zwischen dem zeitlichen Verlauf des Magnetisierungsstroms $i_0(t)$ zum Quadrat und dem zeitlichen Verlauf der Magnetostriktion, also der Längenänderung $\lambda(t)$, über weite Bereiche der magnetischen Flussdichte von kornorientiertem Elektroblech:

$$\lambda(t) \sim i0(t)^2$$

Auch wurde ein von der magnetischen Flussdichte B abhängiger Zusammenhang zwischen dem Peak-to-Peak-Wert der Magnetostriktion $\lambda$pp und dem Peak-to-Peak-Wert des Leerlaufstroms i0pp$^2$ festgestellt:

$$\lambda\text{pp} = c * f(B) * i0\text{pp}^2$$

Insofern kann in einer Ausführungsvariante der Erfindung vorgesehen sein, dass der Peak-to-Peak Wert des zeitlichen Verlaufs des Quadrats des Magnetisierungsstroms zur Bestimmung des Maßes für die Geräuschentwicklung herangezogen wird.

Das bedeutet, dass alleine aufgrund des Magnetisierungsstroms ein Maß für die Magnetostriktion bzw. Längenänderung abgeleitet werden kann und dass, ohne einen zusätzlichen Messaufbau mit Messsensoren, eine Klassifizierung von Elektroblech bezüglich Magnetostriktion mittels des Magnetisierungsstroms durchgeführt werden kann.

Es genügt somit die Messung des Magnetisierungsstroms, die ohnehin für die Messung der Verlustleistung bei standardisierten Methoden geschieht, wie z.B. mittels Epstein-Rahmen oder Single-Sheet Messgerät. Auch könnte für das erfindungsgemäße Verfahren die Erregerwicklung der WO 2011/012159 A1 verwendet werden.

Erfindungsgemäß ist vorgeschlagen, dass als Spule die Primärwicklung eines Epstein-Messgeräts verwendet wird.

Alternativ kann vorgesehen sein, dass als Spule die Primärwicklung eines Single-Sheet Messgerätes verwendet wird.

Beim erfindungsgemäßen Verfahren sind keine zusätzlichen Messgeräte, wie Dehnmessstreifen, Laserinterferometer, oder Sensoren, wie Beschleunigungssensoren, nötig. Ein komplexer Messaufbau kann daher entfallen.

Durch Vergleichsmessungen für Elektrobleche mit bekanntem Zusammenhang zwischen dem Quadrat des Magnetisierungsstroms und der Magnetostriktion können die Faktoren c * f(B) bestimmt werden und damit aus den Messungen des Magnetisierungsstroms für unbekannte Elektrobleche jeweils die Magnetostriktion berechnet werden. Aus der bekannten Magnetostriktion für bekannte Elektrobleche kann eine Klassifizierung der Geräuschentwicklung getroffen werden, also einem bestimmten Wert der Magnetostriktion ein bestimmtes Maß für die Geräuschentwicklung zugeordnet werden.

Wird dann für ein unbekanntes Elektroblech der Magnetisierungsstrom gemessen und dessen Quadrat bestimmt, so kann mittels der oben angegebenen Formeln die Magnetostriktion berechnet werden und aufgrund der bekannten Zusammenhänge zwischen Magnetostriktion und Geräuschentwicklung der berechneten Magnetostriktion ein Maß für die Geräuschentwicklung zugeordnet werden.

KURZE BESCHREIBUNG DER FIGUR

Zur weiteren Erläuterung der Erfindung wird im nachfolgenden Teil der Beschreibung auf die Figur Bezug genommen, aus der weitere vorteilhafte Einzelheiten und mögliche Einsatzgebiete der Erfindung zu entnehmen sind. Die Figur ist als beispielhaft zu verstehen und soll den Erfindungscharakter zwar darlegen, ihn aber keinesfalls einengen oder gar abschließend wiedergeben. Es zeigt:

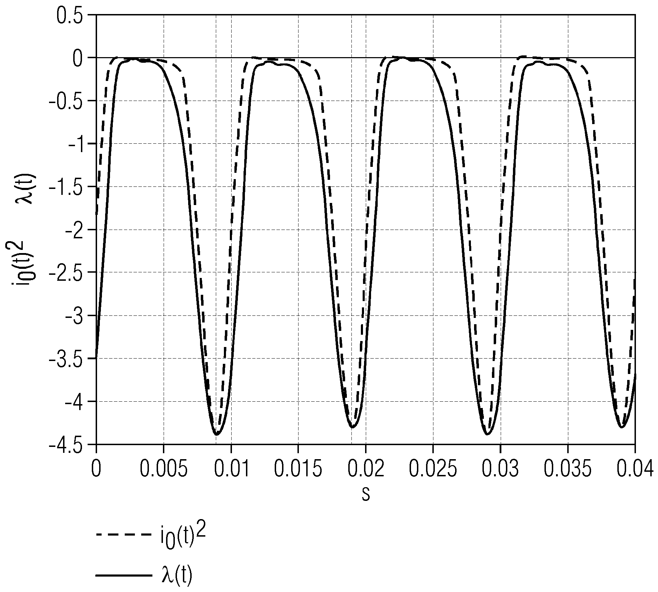

Fig. 1    ein Diagramm mit dem Verlauf des Quadrats des Stroms sowie der Magnetostriktion über die Zeit.

WEGE ZUR AUSFÜHRUNG DER ERFINDUNG

Zur Durchführung eines Verfahrens kann eine beliebige Spule herangezogen werden, die mit einer Spannungsquelle und einem Strommessgerät verbunden ist. So kann etwa die Erregerwicklung der WO 2011/012159 A1 verwendet werden, welche mit einem Strommessgerät verbunden wird. Dies hätte den Vorteil, dass ein ganzer Elektroblechwickel, also ein ganzer aufgerollter Bund Elektroblech, auf einmal untersucht werden kann. Erfindungsgemäß wird ein Epstein- oder Single-Sheet Messgerät verwendet, wo die Primärwicklung verwendet wird.

Fig. 1 zeigt den Verlauf des Quadrats des gemessenen Magnetisierungsstroms i0(t) in einer Spule, siehe strichlierte Linie, sowie den Verlauf der Magnetostriktion $\lambda(t)$, siehe durchgehende Linie, über die Zeit. Diese Daten können z.B. durch Messung des Stroms in der Erregerwicklung der WO 2011/012159 A1 sowie durch die Messergebnisse der Beschleunigungssensoren der WO 2011/012159 A1 erhalten werden. Zur besseren Vergleichbarkeit wird der Wert des Quadrats des Magnetisierungsstroms dargestellt und beide Kurven auf einen gemeinsamen Peak-to-Peak Wert mit entsprechenden Faktoren c*f(B) skaliert.

Aus Fig. 1 ist ersichtlich, dass beide Kurven einen sehr ähnlichen Verlauf haben, wobei die Periodizität der Kurve auf die Frequenz der an der Spule anliegenden Wechselspannung zurückzuführen ist.

Beim erfindungsgemäßen Verfahren würde man den Magnetisierungsstrom i0(t) messen, dessen Quadrat bestimmen und aus dieser Kurve den Abstand zwischen höchstem Punkt, in Fig. 1 bei 0, und tiefstem Punkt, in Fig. 1 bei -4,4, bestimmen. Der Abstand beträgt hier 4,4. Aufgrund von Vergleichsmessungen könnte z.B. schon festgestellt worden sein, dass dieser Abstand nicht größer als 4 sein sollte, um eine zu hohe Geräuschentwicklung zu vermeiden.

Man könnte aus dem quadratischen Stromwert aber auch mittels der Formel

$$\lambda pp = c * f(B) * i0pp^2$$

bei bekannten Werten c und f(B) die Magnetostriktion λpp berechnen und diese mit bekannten Werten für die Magnetostriktion vergleichen, für welche die damit in Verbindung stehende Geräuschentwicklung bekannt ist. Dann kann eine Aussage getroffen werden, ob der berechnete Wert der Magnetostriktion eine noch zulässige, weil niedrige Geräuschentwicklung mit sich bringt, oder ob der berechnete Wert der Magnetostriktion mit einer unzulässig hohen Magnetostriktion verbunden ist.

**Patentansprüche**

1. Verfahren zur Klassifizierung des Geräuschverhaltens von ferromagnetischen Materialien, insbesondere von Elektroblech das für die Herstellung einer elektrischen Maschine verwendet wird, wobei eine Spule mit Wechselspannung beaufschlagt und zur Magnetisierung des Materials am zu klassifizierenden Material angeordnet wird, wobei

    - der in der Spule vorliegende Magnetisierungsstrom über die Zeit gemessen wird, und
    - das Quadrat des Magnetisierungsstroms bestimmt und zur Bestimmung des Maßes für die Geräuschentwicklung herangezogen wird, wobei als Spule die Primärwicklung eines Epstein-Messgeräts oder eines Single-Sheet-Messgerätes verwendet wird.

2. Verfahren nach Anspruch 1, wobei der Peak-to-Peak Wert des zeitlichen Verlaufs des Quadrats des Magnetisierungsstroms zur Bestimmung des Maßes für die Geräuschentwicklung herangezogen wird.

**Claims**

1. Method for classifying the noise behaviour of ferromagnetic materials, in particular of electrical steel sheet which is used for the production of an electric machine, wherein an alternating voltage is applied to a coil and the coil is arranged on the material that is to be classified in order to magnetize the material, wherein

    - the magnetization current present in the coil is measured over time, and
    - the square of the magnetization current is determined and used to determine the extent of the noise development, wherein the primary winding of an Epstein measuring device or of a single-sheet measuring device is used as the coil.

2. Method according to Claim 1, wherein the peak-to-peak value of the temporal profile of the square of the magnetization current is used to determine the extent of the noise development.

**Revendications**

1. Procédé de classement du comportement de bruits de matériaux ferromagnétiques, en particulier d'une tôle électrique que l'on utilise pour la fabrication d'une machine électrique, dans lequel on applique une tension alternative à une bobine et, pour l'aimantation du matériau, on la met sur du matériau à classer, dans lequel

    - on mesure le courant d'aimantation présent dans la bobine en fonction du temps, et
    - on détermine le carré du courant d'aimantation et on en tire parti pour la détermination de la mesure du développement de bruit, dans lequel on utilise, comme bobine, l'enroulement primaire d'un appareil de mesure d'Epstein ou d'un appareil de mesure single sheet.

2. Procédé suivant la revendication 1, dans lequel on tire parti de la valeur de crête à crête de la courbe en fonction du temps du carré du courant d'aimantation pour la détermination de la mesure du développement de bruit.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2011012159 A1

- US 8849587 B1

**In der Beschreibung aufgeführte Nicht-Patentliteratur**

- Diagnosing Winding and Core Condition of Power Transformer by Vibration Signal Analysis. **VON BUYUNG SOFIARTO MUNIER et al.** Condition monitoring and Diagnosis (CMD) 2012 International Conference On. IEEE, 23 September 2012, 429-432